# EUROPÄISCHE PATENTANMELDUNG

(11) **EP 0 942 070 A1**
(43) Veröffentlichungstag der Anmeldung: **15.09.1999**
(21) Anmeldenummer: 99103966.0
(22) Anmeldetag: 09.03.1999
(51) Int. Cl.: C22B 11/00, C22B 7/00, C08J 11/24, B29B 17/02

(54) **Rückgewinnung von Wertmetallen aus Polyester-Leiterplatten durch Aufbereitung in einer alkalischen Lösung mehrwertiger Alkohole**

(30) Priorität: 13.03.1998 DE 19810874
(71) Anmelder: Delphi Technologies, Inc., Troy, MI 48007 (US)
(72) Erfinder: Adam, Frank, 42369 Wuppertal (DE); Tiedeck, Rüdiger, 40764 Langenfeld (DE); Schneider, Manfred, 66359 Bons (DE)
(74) Vertreter: Cohausz & Florack

(57) **Zusammenfassung**

Es wird ein Verfahren zur Aufbereitung von Edel- und/oder Halbedelmetallen wie Kupfer, Silber und Platin aus Polyester-Leiterplatten beschrieben, worin die Leiterplatte mit einer alkalischen Lösung aus einem oder mehreren mehrwertigen Alkoholen bei einer Temperatur von 100 bis 300 °C behandelt und das Edel- und/oder Halbedelmetall anschließend von der flüssigen Phase abgetrennt wird. Das Verfahren ermöglicht die gleichzeitige Wiedergewinnung von Metall und Polyestergrundstoff aus Leiterplatten, wobei die Ausbeute an wiedergewonnenen Metall bis zu 100 % beträgt.

## Beschreibung

Die Erfindung betrifft ein Verfahren zur Aufbereitung von Edel- und/oder Halbedelmetallen aus Polyester-Leiterplatten.

Polyester-Leiterplatten finden als gedruckte Schaltungen in den verschiedensten elektrischen Geräten Verwendung. Wegen ihrer Flexibilität eignen sie sich insbesondere für Anwendungen in der Automobilelektrik, wo elektrische Schaltungen in besonderem Maße Schwingungen und mechanischen Belastungen ausgesetzt sind. Sie bestehen in der Regel aus einer Polyester-Trägerplatte, insbesondere aus einer Polyethylenterephtalat (PETP)-Trägerplatte, die gegebenenfalls glasfaserverstärkt sein kann und auf die eine Vielzahl von strukturierten Leiterbahnen aus Edel- und/oder Halbedelmetall auflaminiert ist. Als Edel- und/oder Halbedelmetall (im folgenden auch kurz als "Metall" bezeichnet) werden vor allem Kupfer, in besonderen Fällen auch Silber und Platin und deren Legierungen verwendet. Die Oberseite der Leiterplatte, auf der sich die Leiterbahnen befinden, kann ferner mit einer isolierenden Lackierung oder Folie beschichtet sein.

In jüngerer Zeit ist man wegen ihres Gehalts an wertvollem Metall dazu übergegangen, für den Abfall bestimmte Leiterplatten wiederaufzubereiten und das darin enthaltene Metall zur Herstellung von neuen Leiterplatten wiederzuverwenden.

Es sind verschiedene Verfahren zur Wiederaufbereitung von Metall aus Leiterplatten bekannt. In den bekannten Verfahren werden die nicht mehr verwendbaren Leiterplatten zunächst zerkleinert und anschließend zu einem feinen Pulver zermahlen. Das in dem Pulver enthaltene Metall kann nun mittels verschiedener Verfahren von den übrigen Inhaltsstoffen abgetrennt werden. So ist zum Beispiel bekannt, die Inhaltsstoffe aufgrund ihrer verschiedenen Dichten voneinander zu trennen. In einem anderen, als 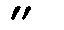 Corona refining" bezeichneten Verfahren, wird das fein zermahlene Pulver durch ein elektrisches Feld geführt, wobei sich der Kunststoff elektrisch auflädt und so von dem Metall getrennt werden kann.

Nachteilig an den bekannten mechanischen Aufbereitungsverfahren für Polyester-Leiterplatten ist, daß die Ausbeute an wiedergewonnenem Metall nur etwa 40 %, bezogen auf die in den Platinen enthaltene Gesamtmenge an Metall, beträgt. Die geringe Ausbeute ist darauf zurückzuführen, daß durch das Zermahlen der Platinen die Metallschicht nicht vollständig von dem Kunststoffträgermaterial gelöst werden kann und mit dem Kunststoff auch im fein zermahlenen Pulver verbunden bleibt. Nachteilig an den bekannten Aufbereitungsverfahren ist ferner, daß der hierdurch gewonnene Kunststoff wegen seiner Verunreinigung durch Metall, Kleber und Lack nicht mehr weiterverwendet werden kann und als Abfall anfällt.

Aus der US 3 544 622 ist die alkalische Verseifung von reinem Polyethylenterephtalat bekannt, wobei PETP mit Natriumhydroxid, Ethylenglykol und Wasser bei Atmosphärendruck und Temperaturen von 100 bis 150 °C behandelt wird. Dabei fällt Dinatriumterephthalat an. Die US 4 078 143 schlägt vor, wie bei dem zuvor genannten Verfahren die Bildung von Diethylenglykol vermieden werden kann.

Der Erfindung liegt die Aufgabe zugrunde, ein Verfahren zur Aufbereitung von Polyester-Leiterplatten bereitzustellen, mit dem mit eine vollständige Abtrennung der darin enthaltenen Edel- und/oder Halbedelmetalle erzielt werden kann.

Diese Aufgabe wird durch ein Verfahren zur Aufbereitung von Edel- und/oder Halbedelmetallen aus Polyester-Leiterplatten gelöst, worin man die Leiterplatte mit einer alkalischen Lösung aus einem oder mehreren mehrwertigen Alkoholen bei einer Temperatur von 100 bis 300°C behandelt und das Edel- und/oder Halbedelmetall anschließend von der flüssigen Phase trennt.

Die erfindungsgemäß erzielte Ausbeute an wiederaufbereitetem Metall beträgt dabei bis zu 100 %, bezogen auf die Gesamtmenge des in den Leiterplatten enthaltenen Metalls.

Überraschend war, daß die auf den Leiterbahnen befindlichen Deckschichten, isolierende Lackierung oder Folie, durch das erfindungsgemäße Verfahren problemlos abgelöst werden und keinem chemischen Angriff unterliegen.

Vorteilhaft ist, daß der in den Leiterplatten enthaltene Polyester zersetzt wird und als Polyesterpolyol anfällt, der wiederum als Grundstoff zur Herstellung von Polyester verwendet werden kann. Gegenüber dem bisherigen Verfahren entfällt das zeit- und kostenaufwendige Zermahlen der Leiterplatten.

Das erfindungsgemäße Verfahren eignet sich für alle Arten von Leiterplatten, die eine Trägerplatte aus Polyester enthalten. Insbesondere eignet es sich für Leiterplatten, deren Trägermaterial Polyethylenterephthalat (PETP) enthält. Als durch das erfindungsgemäße Verfahren wiederaufzubereitende Metalle kommen sämtliche Edel- und Halbedelmetalle und deren Legierungen in Betracht, insbesondere Kupfer, Silber, Platin und deren Legierungen.

Die wiederaufzubereitenden Leiterplatten können ohne vorherige Zerkleinerung dem erfindungsgemäßen Verfahren unterzogen werden. Es ist jedoch zweckmäßig, diese erst zu zerkleinern. Die Leiterplatten können geschreddert und anschließend gegebenenfalls nachgemahlen werden.

Als mehrwertige Alkohole kommen sämtliche für die Glykolysereaktion von Estern geeignete Alkohole wie Ethylenglykol, Propylenglykol, Dipropylenglykol, aromatische Polyole, Polypropylenglykol, Polyethylenglykol, Diethylenglykol, Neopentylglykol, Butylenglykol sowie gemischte Ether/Estertriole in Frage. Besonders geeignet sind Diole, insbesondere Ethylenglykol und Propylenglykol und/oder Mischungen hieraus.

Um die Alkohollösung alkalisch zu machen, können ihr geeignete Basen zugesetzt werden. Hierzu sind sämtliche Arten von Basen, insbesondere Alkali- und Erdalkalibasen geeignet. Gemäß einer bevorzugten Ausführungsform der Erfindung werden starke Basen wie Natriumhydroxid, Kaliumhydroxid oder Ammoniumhydroxid verwendet. Die Basen werden der Alkohollösung vorzugsweise in katalytischer Menge zugesetzt.

Die Alkohollösung kann darüber hinaus für die Glykolyse von Polyestern gebräuchliche Zusatzstoffe wie Natriumacetat, Kobaltacetat, Manganacetat, Zinkacetat, Bleiacetat und/oder Titan(IV)butylat enthalten. Ferner kann sie Wasser enthalten. Der Anteil an Wasser sollte jedoch möglichst niedrig gehalten werden.

Die Behandlung der Leiterplatten erfolgt vorzugsweise in einem Temperaturbereich von 150 bis 250°C, noch bevorzugter in einem Bereich von 180 bis 220°C.

Im folgenden wird die Erfindung anhand eines Ausführungsbeispiels näher erläutert.

### Beispiel

50 g zerschnittene Polyethylenterephthalat-Leiterplatten mit Kupferbeschichtung und einer Stückgröße von etwa 2 x 2 cm wurden in einem mit einem Wasser gekühlten Rückflußkühler und Magnetrührwerk ausgestatteten 1 l Dreihalskolben gegeben, in dem zuvor 250 ml alkalisches Ethylenglykol vorgelegt wurden, das mit 1 bis 2 Kaliumhydroxid-Plätzchen alkalisch gemacht wurde. Die Mischung wurde 2 Stunden bei 180 bis 190°C unter Rückfluß erhitzt. Nach Ablauf der Reaktion wurde die Lösung filtriert, wobei das zurückbleibende Kupfer und der nicht angegriffene Decklack abgetrennt werden konnten.

Die Ausbeute an Kupfer betrug dabei 100 %, bezogen auf die Gesamtmenge des in der Leiterplatte enthaltenen Kupfers.

## Patentansprüche

1. Verfahren zur Aufbereitung von Edel- und/oder Halbedelmetallen aus Polyester-Leiterplatten, **dadurch gekennzeichnet,** daß man die Leiterplatte mit einer alkalischen Lösung aus einem oder mehreren mehrwertigen Alkoholen bei einer Temperatur von 100 bis 300 °C behandelt und das Edel- und/oder Halbedelmetall anschließend von der flüssigen Phase abtrennt.

2. Verfahren nach Anspruch 1, **dadurch gekennzeichnet,** daß die Leiterplatten vor der Behandlung mit der Alkohollösung zerkleinert werden.

3. Verfahren nach Anspruch 1 oder 2, **dadurch gekennzeichnet,** daß der mehrwertige Alkohol ein Diol, insbesondere Ethylenglykol oder Propylenglykol, ist.

4. Verfahren nach einem der Ansprüche 1 bis 3, **dadurch gekennzeichnet,** daß die Temperatur 150 bis 250 °C, insbesondere 180 bis 220 °C, beträgt.
